# EUROPEAN PATENT APPLICATION

(11) **EP 4 807 987 A1**
(43) Date of publication of application: **16.09.2026**
(21) Application number: 24915082.2
(22) Date of filing: 11.12.2024
(51) Int. Cl.: H03H 3/08

(54) **FILTER AND PACKAGING METHOD THEREFOR**

(30) Priority: 05.01.2024 CN 202410017841
(71) Applicant: Vanchip (Tianjin) Technology Co. Ltd, Tianjin 300457 (CN)
(72) Inventor: XU, Xian, Tianjin 300457 (CN); FENG, Dandan, Tianjin 300457 (CN); LIN, Hongkuan, Tianjin 300457 (CN); ZHANG, Xinyao, Tianjin 300457 (CN)
(74) Representative: Patentship Patentanwaltsgesellschaft mbH
(86) International application number: PCT/CN2024/138310
(87) International publication number: WO 2025/145867

(57) **Abstract**

The present invention provides a method of packaging a filter, which includes: providing a substrate formed with a resonant structure on a surface thereof, the resonant structure including a resonance body and electrodes on opposite sides of the resonance body, each having a first portion adjacent to the resonance body and a second portion away from the resonance body; forming, on the first portions of the electrodes, a support wall surrounding the resonance body; forming a second thin-film layer onto a carrier and patterning the second thin-film layer into a roof; aligning the carrier, with its surface, on which the roof is formed, facing the surface of the substrate formed with the resonant structure thereon, and bonding the roof to the support wall so that a cavity necessary for the resonance body is formed; and removing the carrier. This overcomes the problem of poor flatness, uniformity and adhesion strength of a film laminated onto a support wall to create a cavity, resulting in increased reliability of the resulting filter. Moreover, it entails a low-cost process with reduced control complexity and high product yield. The present invention also provides a filter obtainable according to the method

## Description

### TECHNICAL FIELD

The present invention relates to the field of packaging technology, and more particularly to a filter and a method of packaging it.

### BACKGROUND

As an important component of a radio frequency (RF) front-end, a surface acoustic wave (SAW) filter operates based on the propagation of acoustic waves along the surface of an associated chip. Accordingly, the packaging of a SAW filter is required to ensure that the surface of an interdigital transducer (IDT) therein is not in contact with anything else. That is, a sufficient space must be reserved for operation of the IDT.

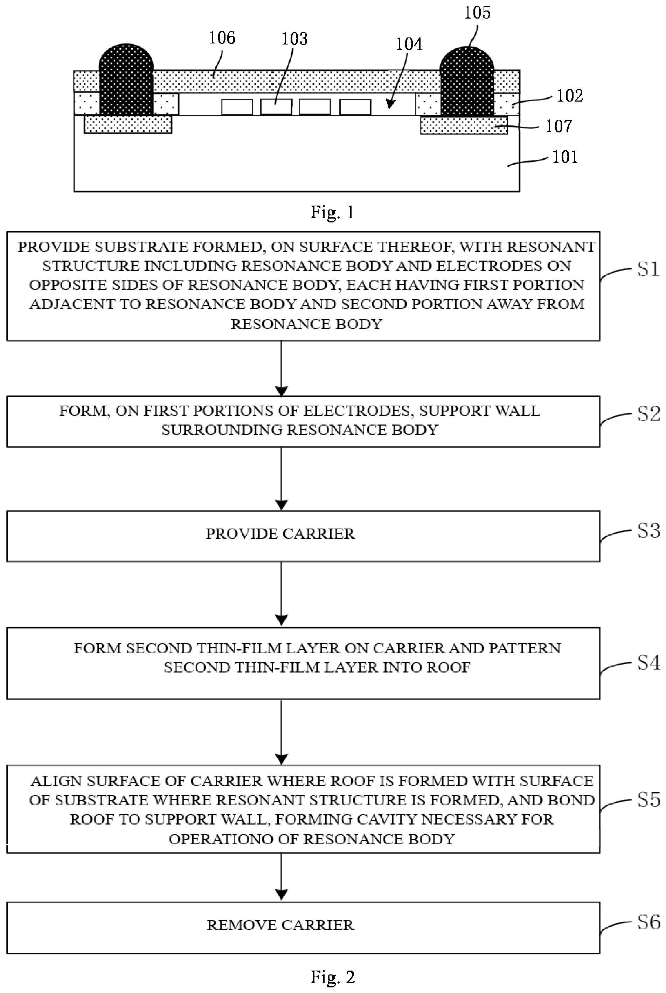

Fig. 1 shows a schematic cross-sectional view of a conventional filter. Referring to Fig. 1, the filter can be packaged using a method including: forming a first polyimide (PI) film onto the surface of a wafer 101 and performing an exposure, development and etching process thereon, thereby forming a support wall 102; forming a second PI film, as a roof 106, over the surface of the wafer 101, thereby creating a cavity 104 necessary for operation of the IDT 103; performing another exposure, development and etching process to remove the first and second PI films above signal ports 107, thereby exposing the signal ports 107; and forming solder paste, or placing solder balls, onto the exposed signal ports 107, followed by reflow soldering process, thereby forming pins 105 for external connection of the signal ports 107. However, a disadvantage of this method is that the second PI film applied onto the support wall 102 tends to lack flatness, uniformity and adhesion strength. This in turn tends to lead to reliability issues, such as collapse of the roof into the cavity and peeling of the roof.

Another conventional method of packaging a filter includes: forming an amorphous layer in a first wafer using an ion implantation process; etching the first wafer, thereby forming, on one side thereof, a cap on top of the amorphous layer; bonding the cap on the first wafer to a second wafer formed with an IDT on its surface, thereby forming a cavity necessary for operation of the IDT; and separating the cap from the rest of the first wafer along the amorphous layer. However, in this method, the formation and bonding of the cape are complex and costly, and it is difficult for the ion implantation process to create a flat, uniform amorphous layer with a desired thickness. Therefore, it suffers from high process control complexity and low product yield.

### SUMMARY

It is an object of the present invention to provide a filter and a method of packaging the filter, which overcomes the problem of poor flatness, uniformity and adhesion strength of a film laminated onto a support wall to create a cavity, resulting in increased reliability of the resulting filter. Moreover, it entails a simple, low-cost process with reduced process control complexity and high product yield.

To this end, in an aspect of the present invention, there is provided a method of packaging a filter, which includes: providing a substrate formed with a resonant structure on a surface thereof, the resonant structure including a resonance body and electrodes on opposite sides of the resonance body, each having a first portion adjacent to the resonance body and a second portion away from the resonance body; forming, on the first portions of the electrodes, a support wall surrounding the resonance body; providing a carrier; forming a second thin-film layer onto the carrier and patterning the second thin-film layer into a roof; aligning the carrier, with its surface, on which the roof is formed, facing the surface of the substrate formed with the resonant structure thereon, and bonding the roof to the support wall so that a cavity necessary for the resonance body is formed; and removing the carrier

Optionally, forming the support wall on the first portions of the electrodes may include: forming a first thin-film layer onto the substrate; and patterning the first thin-film layer into the support wall.

Optionally, the first thin-film layer may be made of the same material as the second thin-film layer.

Optionally, the second thin-film layer may include a polyimide (PI) film, an epoxy resin film or a semiconductor layer.

Optionally, the provided carrier may have an adhesive layer on its surface, wherein the second thin-film layer is applied onto the adhesive layer.

Optionally, the method may further include: after the carrier is removed, forming a redistribution layer over the substrate, which partially resides on the roof, with the remainder thereof covering the second portions of the electrodes and thereby being electrically connected to the electrodes; and forming signal pins on the redistribution layer.

Optionally, the signal pins may be located on the redistribution layer on the roof.

Optionally, the signal pins may be aligned with the support wall.

Optionally, the support wall may be annular, wherein a width of the roof is greater than a width of the support wall defined by its inner edges and less than or equal to a width of the support wall defined by its outer edges.

In another aspect of the present invention, there is provided a filter obtained according to the method defined above.

As noted above, the present invention provides a filter and a method of packaging the filter, in which a support wall is formed on first portions of electrodes, and a roof is formed on a carrier and then bonded to the support wall thereby forming a cavity necessary for operation of a resonance body. This circumvents the formation of a cavity by laminating a film onto the support wall, which may suffer from poor flatness, uniformity and adhesion strength of the laminated film, and hence from proneness of the cavity to deformation and of the roof to peeling, improving reliability of the resulting filter. In addition, it entails a simple, low-cost process with reduced process control complexity and high product yield.

Further, after the carrier is removed, a redistribution layer is formed on the substrate, which is electrically connected to the electrodes and covers part of the roof, and signal pins are then formed on the redistribution layer on the roof. Thus, the signal pins are located at the top of the filter, facilitating the expulsion of air around the signal pins during subsequent secondary packaging of the filter in a flipped configuration onto a substrate. Consequently, an encapsulating material can be fully filled around the signal pins, mitigating the problem of possible presence of voids around the signal pins.

### BRIEF DESCRIPTION OF THE DRAWINGS

Fig. 1 shows a schematic cross-sectional view of a conventional filter.
Fig. 2 shows a flowchart of a method of packaging a filter according to an embodiment of the present invention.
Figs. 3 to 10 show schematic diagrams illustrating steps in a method of packaging a filter according to an embodiment of the present invention.
Fig. 11 shows a schematic cross-sectional view of a filter according to an embodiment of the present invention.

### List of Reference Numerals

(Fig. 1) 101 wafer; 102 support wall; 103 IDT; 104 cavity; 105 pin; 106 roof; 107 signal port;

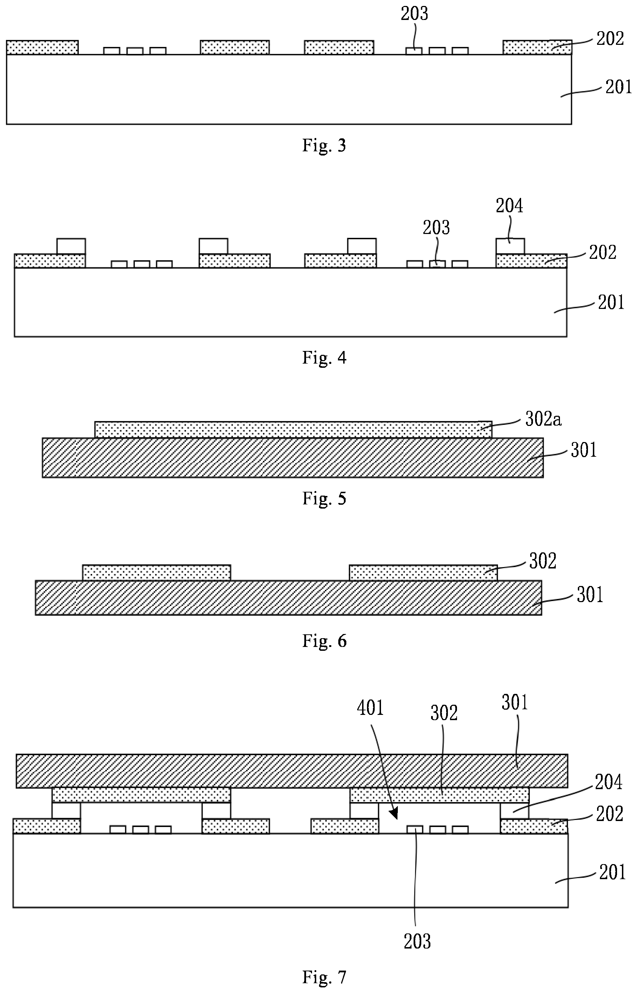

(Figs. 3 to 11) 201 substrate; 202 electrode; 202a second portion of electrode; 203 resonance body; 204 support wall; 301 carrier; 302a second thin-film layer; 302 roof; 401 cavity; 402 redistribution layer; 403 signal pin.

### DETAILED DESCRIPTION

Filters and methods of packaging a filter proposed in specific embodiments of the present invention will be described in greater detail below with reference to the accompanying drawings. From the following description, advantages and features of the present invention will become more apparent. Note that the figures are provided in a very simplified form not necessarily drawn to exact scale for the only purpose of facilitating easy and clear description of the embodiments disclosed herein.

As used herein, the singular forms "a", "an", and "the" are intended to include the plural forms as well, and the term "or" is generally employed in the sense of "and/or". Unless defined otherwise herein, the terms "upper", "upper layer", "lower", "lower layer" and/or the like are merely for ease of description, and should not be construed as being limited to a particular position, or to a particular spatial orientation. The terms "first," "second," and "third" are intended only for illustration and are not to be construed as indicating or implying relative importance, or as implicitly indicating the number of the referenced items. Accordingly, defining an item with "first", "second" or "third" is an explicit or implicit indication of the presence of one or at least two such items.

In principle, the present invention proposes to fabricate a roof on a carrier in advance and then bond the roof to a support wall on electrodes, thereby forming a cavity necessary for a resonance body, followed by removal of the carrier. This circumvents the formation of a cavity by laminating a film onto the support wall, which may suffer from poor flatness, uniformity and adhesion strength of the laminated film, and hence from proneness of the cavity to deformation and of the roof to peeling, improving reliability of the resulting filter. In addition, it entails a simple, low-cost process with reduced process control complexity and high product yield.

Fig. 2 shows a flowchart of a method of packaging a filter according to an embodiment of the present invention. As shown in Fig. 2, a method of packaging a filter according to an embodiment of the present invention includes the steps of:
S1) providing a substrate formed with a resonant structure on a surface thereof, the resonant structure including a resonance body and electrodes on opposite sides of the resonance body, each having a first portion adjacent to the resonance body and a second portion away from the resonance body;
S2) forming, on the first portions of the electrodes, a support wall surrounding the resonance body;
S3) providing a carrier;
S4) forming a second thin-film layer onto the carrier and patterning the second thin-film layer into a roof;
S5) aligning the carrier, with its surface, on which the roof is formed, facing the surface of the substrate formed with the resonant structure thereon, and bonding the roof to the support wall so that a cavity necessary for the resonance body is formed; and
S6) removing the carrier.

It is to be understood that although the steps in the flowchart of Fig. 2 are shown in sequential order as indicated by the arrows, they are not necessarily performed in that order. Unless otherwise specified herein, these steps are not limited to being performed strictly in any particular order and may be performed in any other suitable order than that shown in the figure. Moreover, at least some of the steps in the flowchart of Fig. 2 may include multiple sub-steps or phases, which are not necessarily performed at the same time and may be performed at different times. In addition, these sub-steps or phases are not necessarily performed in any particular order. Rather, they may be performed alternately with other steps or at least some sub-steps or phases thereof.

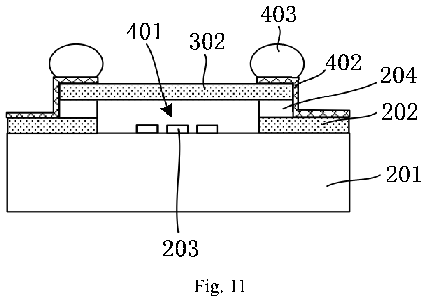

Figs. 3 to 10 show schematic diagrams illustrating steps in a method of packaging a filter according to an embodiment of the present invention. Fig. 11 shows a schematic cross-sectional view of a filter according to an embodiment of the present invention. A method of packaging a filter according to an embodiment of the present invention will be described below with reference to Figs. 2 and 3 to 11.

In step S1, as shown in Fig. 3, a substrate 201 is provided, a resonant structure is formed on a surface of the substrate 201. The resonant structure includes a resonance body 203 and electrodes 202 on opposite sides of the resonance body 203. Each electrode 202 has a first portion adjacent to the resonance body 203 and a second portion away from the resonance body 203.

For example, the resonance body 203 may be an interdigital transducer (IDT). Step S1 may include: forming a metal layer on the surface of the substrate 201; patterning the metal layer to form the resonance body 203 and the electrodes 202 on the opposite sides of the resonance body 203; and electroplating a metal onto the surfaces of the electrodes 202, thus increasing their height. Increasing the height of the electrodes 202 by electroplating the metal onto their surfaces means an increased height of a subsequently formed cavity, which ensures that the cavity can support proper operation of the resonance body 203.

For example, the substrate 201 may be a piezoelectric substrate. Piezoelectric materials suitable for the piezoelectric substrate may include aluminum nitride (AlN), quartz, lithium niobate and lithium tantalite. Suitable materials for the metal layer, from which the IDT is fabricated from, may include aluminum (Al), copper (Cu), gold (Au), silver (Ag), chromium (Cr), titanium (Ti), tungsten (W) and other metals, as well as alloys thereof. Examples of the metal electroplated on the electrodes 202 may include nickel-gold (NiAu) and nickel-palladium-gold (NiPdAu), among others. Without limitation, the electrodes 202 may have a thickness of 1 µm to 5 µm.

In step S2, as shown in Fig. 4, a support wall 204 is formed on the first portions of the electrodes 202, the support wall 204 surrounds the resonance body 203.

In particular, step S2 may include: forming a first thin-film layer onto the substrate 201, which covers the surfaces of the electrodes 202, the resonance body 203 and the substrate 201; and patterning the first thin-film layer so that the first thin-film layer on the first portions of the electrodes 202 are retained as the support wall 204, with the remainder of the first thin-film layer being removed.

Non-limiting examples of the first thin-film layer may include a polyimide (PI) film, an epoxy resin film, or a semiconductor layer, such as a silicon wafer. Alternatively, the first thin-film layer may be a photoresist layer, which allows the support wall 204 to be formed by performing an exposure and development process on the first thin-film layer. This process is simple and allows for accurate formation of the support wall 204. Still alternatively, the first thin-film layer may be a non-photosensitive material. In this case, before the first thin-film layer is patterned, a mask layer may be formed thereon. Subsequently, the first thin-film layer may be etched while being protected by the mask layer, thereby forming the support wall 204.

Referring to Fig. 3, a plurality of resonant structures may be formed on the substrate 201, allowing for simultaneous packaging of multiple filters. In this way, higher packaging efficiency can be obtained.

In steps S3 and S4, referring to Figs. 5 and 6, a carrier 301 is provided, and a second thin-film layer 302a is applied onto the carrier 301. The second thin-film layer 302a is then patterned into a roof 302. As shown in Fig. 6, a plurality of roofs 302 may be formed simultaneously on the carrier 301.

For example, the carrier 301 may be a rigid carrier, such as a wafer or glass plate.

An adhesive layer (not shown) may be applied to the surface of the carrier 301, and the second thin-film layer 302a may be attached to the adhesive layer. This facilitates subsequent separation of the carrier 301 from the roof 302.

Non-limiting examples of the second thin-film layer 302a may include a PI film, an epoxy resin film, or a semiconductor layer, such as a silicon wafer. Alternatively, the second thin-film layer 302a may be a photoresist layer, which allows the roof 302 to be formed by performing an exposure and development process on the second thin-film layer 302a. This process is simple and allows for accurate formation of the roof 302. Still alternatively, the first thin-film layer may be a non-photosensitive material. In this case, before the second thin-film layer 302a is patterned, a mask layer may be formed thereon. Subsequently, the second thin-film layer 302a may be etched while being protected by the mask layer, thereby forming the roof 302.

Preferably, the second thin-film layer 302a is made of the same material as the first thin-film layer. In this case, higher bonding reliability, and hence improved reliability of the filter being fabricated, can be obtained due to the absence of any significant coefficient of thermal expansion (CTE) difference between the support wall 204 and the roof 302 because they are made of the same material. According to alternative embodiments disclosed herein, the support wall 204 and the roof 302 may be made of different materials, such as different resin- or PI- based materials. Still alternatively, the roof 302 may be made of silicon, glass or the like.

In step S5, referring to Fig. 7, the carrier 301 is oriented, with its surface, on which the roof 302 is formed, facing the surface of the substrate 201 formed with the resonant structure thereon, and the roof 302 is then bonded to the support wall 204, thereby forming a cavity 401 necessary for the operation of the resonance body 203.

The bonding of the roof 302 to the support wall 204 may be accomplished by, for example, by hot-press bonding.

Referring to Fig. 7, the support wall 204 may be annular, and the roof 302 may have a width, which is greater than a width of the support wall 204 defined by its inner edges and less than or equal to a width of the support wall 204 defined by its outer edges. With this arrangement, after being aligned and bonded to the support wall 204, the roof 302 does not occlude the second portions of the electrodes 202.

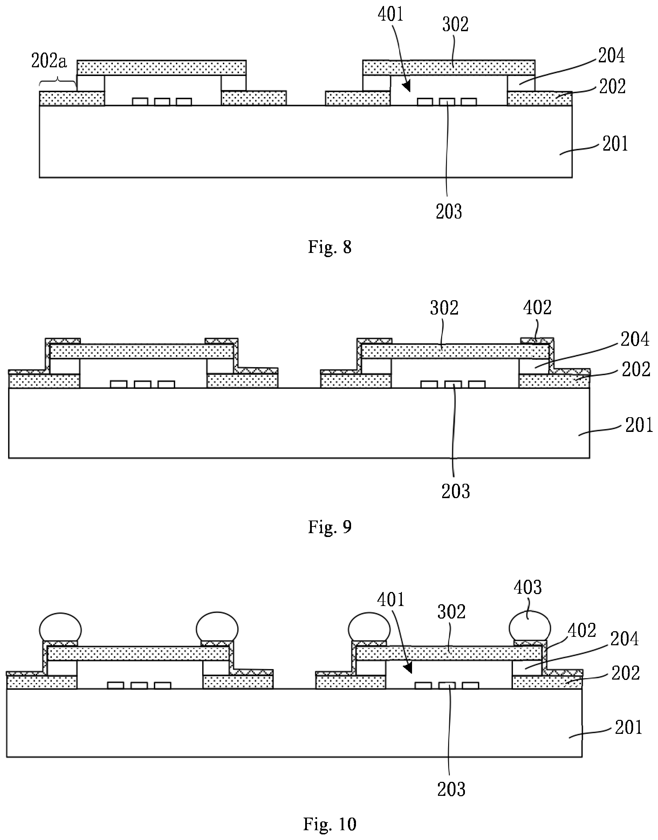

In step S6, as shown in Fig. 8, the carrier 301 is removed, exposing the second portions 202a of the electrodes.

Next, referring to Fig. 9, a redistribution layer 402 is formed over the substrate 201 so as to partially reside on the roof 302, with the remainder of the redistribution layer 402 covering the second portions of the electrodes 202 and thereby being electrically connected to the electrodes 202.

The redistribution layer 402 may be formed by using an electroplating process. The redistribution layer 402 may be formed of a metal, such as copper.

It should be noted that, as shown in Figs. 8 and 9, the support wall 204 is bonded to the first portions of the electrodes 202, with the second portions 202a of the electrodes being reserved. Thus, after the carrier 301 is removed, the second portions 202a of the electrodes will be completely exposed, and the redistribution layer 402 may be directly formed on the second portions of the electrodes 202. This entails a simple process.

Referring to Fig. 10, signal pins 403 are formed on the redistribution layer 402.

In the present embodiment, the signal pins 403 may be solder balls. The formation of the signal pins 403 on the redistribution layer 402 may include: placing solder balls onto the redistribution layer 402; and performing a reflow soldering process to melt the solder balls onto the redistribution layer 402, thereby forming the signal pins 403. In an alternative embodiment, the signal pins 403 may be formed on the redistribution layer 402 using an electroplating process.

Referring to Fig. 10, the signal pins 403 may be formed on the redistribution layer 402 on the roof 302. Thus, the signal pins are located at the top of the filter being fabricated, facilitating the expulsion of air around the signal pins during subsequent secondary packaging of the filter in a flipped configuration onto a substrate. Consequently, an encapsulating material can be fully filled around the signal pins, mitigating the problem of possible presence of voids around the signal pins.

In the present embodiment, the signal pins 403 are aligned with the support wall 204. That is, the signal pins 403 are located directly above the support wall 204. If the signal pins 403 are instead formed directly above the cavity 401, reliability of the cavity may be adversely affected.

Referring to Figs. 10 and 11, in the case of a plurality of resonant structures, the substrate 201 is diced, thereby obtaining a plurality of individual filters.

Embodiments of the present invention also provide a filter obtainable according to the method discussed above.

Referring to Fig. 11, the filter includes a substrate 201, a resonant structure, a support wall 204 and a roof 302. The resonant structure is formed on a surface of the substrate 201 and includes a resonance body 203 and electrodes 202 on opposite sides of the resonance body 203. Each electrode 202 includes a first portion adjacent to the resonance body 203 and a second portion away from the resonance body 203. The support wall 204 is formed on the first portions of the electrodes 202. The support wall 204 surrounds the resonance body 203. The roof 302 is formed on a carrier in advance, and the roof 302 is bonded to the support wall 204, thereby forming a cavity 401 necessary for the operation of the resonance body 203.

The filter further includes a redistribution layer 402 and signal pins 403. The redistribution layer 402 partially resides on the roof 302, with the remainder of the redistribution layer 402 covering the second portions of the electrodes 202 and thereby being electrically connected to the electrodes 202. The signal pins 403 are formed on the redistribution layer 402 on the roof 302. Preferably, the signal pins 403 are aligned with the support wall 204.

As discussed above, embodiments of the present invention provide a filter and a method of packaging the filter, in which a support wall 204 is formed on first portions of electrodes 202, and a roof 302 is formed on a carrier 301 and then bonded to the support wall 204, thereby forming a cavity 401 necessary for operation of a resonance body 203. This circumvents the formation of a cavity by laminating a film onto the support wall, which may suffer from poor flatness, uniformity and adhesion strength of the laminated film, and hence from proneness of the cavity to deformation and of the roof to peeling, improving reliability of the resulting filter. In addition, it entails a simple, low-cost process with reduced process control complexity and high product yield.

Further, after the carrier 301 is removed, a redistribution layer 402 is formed on the substrate 201, which is electrically connected to the electrodes 202 and covers part of the roof 302, and signal pins 403 are then formed on the redistribution layer 402 on the roof 302. Thus, the signal pins are located at the top of the filter, facilitating the expulsion of air around the signal pins during subsequent secondary packaging of the filter in a flipped configuration onto a substrate. Consequently, an encapsulating material can be fully filled around the signal pins, mitigating the problem of possible presence of voids around the signal pins.

It should be noted that the embodiments disclosed herein are described in a progressive manner, with the description of each embodiment focusing on its differences from others. Cross-reference is made between the embodiments for their common or similar features.

While the invention has been described above with reference to several preferred embodiments, it is not intended to be limited to these embodiments in any way. In light of the teachings hereinabove, any person of skill in the art may make various possible variations and changes to the disclosed embodiments without departing from the spirit or scope of the invention. Accordingly, any and all such simple variations, equivalent alternatives and modifications made to the foregoing embodiments without departing from the scope of the invention are intended to fall within the scope thereof.

## Claims

1. A filter packaging method, comprising:
providing a substrate, a resonant structure formed on a surface of the substrate, the resonant structure comprising a resonance body and electrodes on opposite sides of the resonance body, a surface of each electrode having a first portion adjacent to the resonance body and a second portion away from the resonance body;
forming, on the first portions of the electrodes, a support wall surrounding the resonance body;
providing a carrier;
forming a second thin-film layer on a carrier and performing a patterning treatment on the second thin-film layer to form a roof;
aligning a surface of the carrier where the roof is formed with the surface of the substrate wherein the resonant structure is formed, and bonding the roof to the support wall so that a cavity necessary for an operation of the resonance body is formed; and
removing the carrier.

2. The filter packaging method of claim 1, wherein forming the support wall on the first portions of the electrodes comprising:
forming a first thin-film layer on the substrate; and
performing a patterning treatment on the first thin-film layer to form the support wall.

3. The filter packaging method of claim 2, wherein the first thin-film layer is made of the same material as the second thin-film layer.

4. The filter packaging method of claim 1, wherein the second thin-film layer comprises a polyimide film, an epoxy resin film or a semiconductor layer.

5. The filter packaging method of claim 1, wherein in the step of providing a carrier, the surface of the carrier is formed with an adhesive layer, and the second thin-film layer is formed on the adhesive layer.

6. The filter packaging method of claim 1, further comprising:
after the carrier is removed, forming a redistribution layer over the substrate, which partially resides on the roof, with a remainder of the redistribution layer covering the second portions of the electrodes and thereby being electrically connected to the electrodes; and
forming signal pins on the redistribution layer.

7. The filter packaging method of claim 6, wherein the signal pins are located on the redistribution layer on the roof.

8. The filter packaging method of claim 7, wherein the signal pins are aligned with the support wall.

9. The filter packaging method of any one of claims 1 to 8, wherein the support wall is annular, and wherein a width of the roof is greater than a width of the support wall defined by its inner edges and less than or equal to a width of the support wall defined by its outer edges.

10. The filter packaging method of claim 1, wherein the formation of the resonant structure on the surface of the substrate comprises: forming a metal layer on the surface of the substrate; performing a patterning treatment on the metal layer to form the resonance body and the electrodes on the opposite sides of the resonance body; electroplating a metal on the surfaces of the electrodes, thereby increasing a thickness of the electrodes.

11. The filter packaging method of claim 10, wherein the metal electroplated on the electrode comprises nickel-gold or nickel-palladium-gold.

12. The filter packaging method of claim 1, wherein the second thin-film layer is a photoresist layer.

13. The filter packaging method of claim 6, wherein forming the signal pins on the redistribution layer comprises: placing solder balls onto the redistribution layer; and then performing a reflow soldering process to melt the solder balls onto the redistribution layer, thereby forming the signal pins.

14. The filter packaging method of claim 1, wherein the electrodes have a thickness of 1 µm to 5 µm.

15. A filter, being obtained according to the filter packaging method of any one of claims 1 to 14, the filter comprising:
a substrate, a resonant structure formed on a surface of the substrate, the resonant structure comprising a resonance body and electrodes on opposite sides of the resonance body, a surface of each electrode having a first portion adjacent to the resonance body and a second portion away from the resonance body;
a support wall, which is formed on the first portions of the electrodes so as to surround the resonance body; and
a roof, which is bonded to the support wall so as to form a cavity necessary for an operation of the resonance body.

16. The filter of claim 15, further comprising a redistribution layer, which partially resides on the roof, with a remainder of the redistribution layer covering the second portions of the electrodes and thereby being electrically connected to the electrodes;

17. The filter of claim 16, further comprising signal pins, wherein the signal pins are formed on the redistribution layer on the roof.

18. The filter of claim 17, wherein the signal pins are aligned with the support wall.

19. The filter of claim 15, wherein the support wall is annular, and wherein a width of the roof is greater than a width of the support wall defined by its inner edges and less than or equal to a width of the support wall defined by its outer edges.

20. The filter of claim 15, wherein the electrodes have a thickness of 1 µm to 5 R^{m}.
